# EUROPEAN PATENT APPLICATION

(11) **EP 4 231 302 A1**
(43) Date of publication of application: **23.08.2023**
(21) Application number: 22857315.0
(22) Date of filing: 22.04.2022
(51) Int. Cl.: G11C 29/42

(54) **TEST METHOD AND TEST SYSTEM**

(30) Priority: 19.08.2021 CN 202110955470
(71) Applicant: Changxin Memory Technologies, Inc., Hefei, Anhui 230601 (CN)
(72) Inventor: SUN, Yuanyuan, Hefei, Anhui 230601 (CN); WANG, Jia, Hefei, Anhui 230601 (CN); SHANG, Weibing, Hefei, Anhui 230601 (CN)
(74) Representative: Lavoix
(86) International application number: PCT/CN2022/088485
(87) International publication number: WO 2023/019997

(57) **Abstract**

Embodiments of the present disclosure relate to the field of semiconductor circuit testing, and in particular, to a test method and a test system. The test method comprises: writing first initial data into a storage module, and an ECC module encoding and generating, on the basis of the first initial data, first verification data corresponding to the first initial data, and writing the first verification data into the storage module; writing second initial data into a same address of the storage module; reading the second initial data and the first verification data in the storage module, and the ECC module encoding and generating, on the basis of the second initial data, second verification data corresponding to the second initial data, and verifying and correcting the second initial data on the basis of the first verification data and the second verification data; and reading first read data of a memory, and determining, on the basis of the first read data, whether a function of the ECC module is abnormal, the first read data being the second initial data verified and corrected by the ECC module.

## Description

### CROSS-REFERENCE TO RELATED APPLICATION

The disclosure is based upon and claims priority to Chinese Patent Application No. 202110955470.3, filed on August 19, 2021, the disclosure of which is hereby incorporated by reference in its entirety.

### TECHNICAL FIELD

The disclosure relates, but is not limited to, a test method and a test system.

### BACKGROUND

A Dynamic Random Access Memory (DRAM) is widely applied to modern electronic systems due to its characteristics of high storage density and fast transmission speed. With the development of a semiconductor technology, the DRAM technology has become more and more advanced, and the integration of storage units has become higher and higher. In addition, various applications have higher and higher requirements for the performance, power consumption and reliability of the DRAM.

In order to ensure that data is correctly stored, data check is performed on the stored data by introducing an Error Correction Code (ECC) function, so as to improve the accuracy of data storage of the DRAM. That is to say, the stored data may be guaranteed, to a certain extent, to be correct by guaranteeing the correct operation of the ECC function.

However, the applicant found that the current test environment for the ECC function in the DRAM is relatively limited, so that it is urgent to design a simple and reliable test method to test whether the ECC function in the DRAM is normal.

### SUMMARY

An embodiment of the disclosure provides a test method, applied to a memory including a storage module and an ECC module. The test method includes: first initial data is written into the storage module; the ECC module encodes and generates first check data corresponding to the first initial data based on the first initial data, and writes the first parity data into the storage module; second initial data is written into a same address of the storage module, where the second initial data stored in the storage module covers the first initial data, and there is a data difference between the first initial data and the second initial data; the second initial data and the first check data in the storage module is read, the ECC module encodes and generates second check data corresponding to the second initial data based on the second initial data, checks and corrects the second initial data based on the first check data and the second check data; and first read data of the memory is read, and whether a function of the ECC module is abnormal is determined based on the first read data, where the first read data is the second initial data checked and corrected by the ECC module.

An embodiment of the disclosure provides a test system. The test system is applied to the above test method, and includes: a first data providing module, a second data providing module, a control module and a data analysis module. The first data providing module is configured to provide first initial data to a memory; the second data providing module is configured to provide second initial data to the memory, where there is a data difference between the first initial data and the second initial data; the control module is configured to control the turning on or turning off of an ECC module of the memory according to a control signal; and the data analysis module is configured to acquire first read data outputted by the memory, and determine whether a function of the ECC module is abnormal based on the first read data, where the first read data is the checked and corrected second initial data that is outputted by the memory.

### BRIEF DESCRIPTION OF THE DRAWINGS

In order to more clearly illustrate the technical solutions in the embodiments of the disclosure or conventional technologies, the drawings used in the technical description of the embodiments will be briefly described below. It is apparent that the drawings in the following descriptions are merely some embodiments of the disclosure. Other drawings can be obtained from those skilled in the art according to these drawings without any creative work.
FIG. 1 is a schematic structural diagram of a memory according to an embodiment of the disclosure.
FIG. 2 is a schematic flowchart of a test method according to an embodiment of the disclosure.
FIG. 3 is a schematic flowchart of specific data of a test method according to an embodiment of the disclosure.
FIG. 4 is a schematic structural diagram of another memory according to an embodiment of the disclosure.
FIG. 5 is a schematic structural diagram of a test system according to another embodiment of the disclosure.
FIG. 6 is a schematic structural diagram of another test system according to another embodiment of the disclosure.

### In the drawings:

100-interface module; 115-first data path; 125-second data path; 200-ECC module; 300-storage module; 400-test system; 401-first data providing module; 402-second data providing module; 403-control module; 404-data analysis module; 414-acquisition unit; 424-determination unit; 524-processing unit.

### DETAILED DESCRIPTION

Exemplary embodiments disclosed in the disclosure are described in more detail with reference to drawings. Although the exemplary embodiments of the disclosure are illustrated in the drawings, it should be understood that the disclosure may be implemented in various forms and should not be limited by the specific embodiments described here. On the contrary, these embodiments are provided for more thorough understanding of the disclosure, and to fully convey a scope disclosed in the embodiments of the disclosure to a person skilled in the art.

In the drawings, the sizes of a layer, a region, and an element and their relative sizes may be exaggerated for clarity. The same reference numerals represents the same element throughout.

It should be understood that while the element or the layer is referred to as being "on", "adjacent to", "connected to" or "coupled to" other elements or layers, it may be directly on the other elements or layers, adjacent to, connected or coupled to the other elements or layers, or an intermediate element or layer may be existent. In contrast, while the element is referred to as being "directly on", "directly adjacent to", "directly connected to" or "directly coupled to" other elements or layers, the intermediate element or layer is not existent. It should be understood that although terms first, second, third and the like may be used to describe various elements, components, regions, layers and/or sections, these elements, components, regions, layers and/or sections should not be limited by these terms. These terms are only used to distinguish one element, component, region, layer or section from another element, component, region, layer or section. Therefore, without departing from the teaching of the disclosure, a first element, first component, first region, first layer or first section discussed below may be represented as a second element, second component, second region, second layer or second section. While the second element, second component, second region, second layer or second section is discussed, it does not mean that the first element, first component, first region, first layer or first section is necessarily existent in the disclosure.

Spatial relation terms, such as "under", "below", "lower", "underneath", "above", "upper" and the like, may be used here for conveniently describing so that a relationship between one element or feature illustrated in the drawings and other elements or features is described. It should be understood that in addition to orientations illustrated in the drawings, the spatial relationship terms are intended to further include the different orientations of a device in use and operation. For example, if the device in the drawings is turned over, then the elements or the features described as "below" or "underneath" or "under" other elements may be oriented "on" the other elements or features. Therefore, the exemplary terms "below" and "under" may include two orientations of up and down. The device may be otherwise oriented (rotated by 90 degrees or other orientations) and the spatial descriptions used here are interpreted accordingly.

A purpose of the terms used here is only to describe the specific embodiments and not as limitation to the disclosure. While used here, singular forms of "a", "an" and "said/the" are also intended to include plural forms, unless the context clearly indicates another mode. It should also be understood that terms "composition" and/or "including", while used in the description, determine the existence of the described features, integers, steps, operations, elements and/or components, but do not exclude the existence or addition of one or more other features, integers, steps, operations, elements, components, and/or groups. As used herein, a term "and/or" includes any and all combinations of related items listed.

In order to ensure that data is correctly stored, data check is performed on the stored data by introducing an ECC function, so as to improve the accuracy of data storage of the DRAM. That is to say, the stored data may be guaranteed, to a certain extent, to be correct by guaranteeing the correct operation of the ECC function.

The applicant found that the current test environment for the ECC function in the DRAM is relatively limited, so that it is urgent to design a simple and reliable test method to test whether the ECC function in the DRAM is normal.

An embodiment of the disclosure provides a test method, applied to a memory including a storage module and an ECC module. The test method includes: first initial data is written into the storage module; the ECC module encodes and generates first check data corresponding to the first initial data based on the first initial data, and writes the first parity data into the storage module; second initial data is written into a same address of the storage module, where the second initial data stored in the storage module covers the first initial data, and there is a data difference between the first initial data and the second initial data; the second initial data and the first check data in the storage module is read, the ECC module encodes and generates second check data corresponding to the second initial data based on the second initial data, checks and corrects the second initial data based on the first check data and the second check data; and first read data of the memory is read, and whether a function of the ECC module is abnormal is determined based on the first read data, where the first read data is the second initial data checked and corrected by the ECC module.

It is to be understood by those skilled in the art that, in each embodiment of the disclosure, many technical details are provided for readers to better understand the disclosure. However, even without these technical details and various changes and modifications based on the following embodiments, the technical solutions claimed in the disclosure may also be realized.

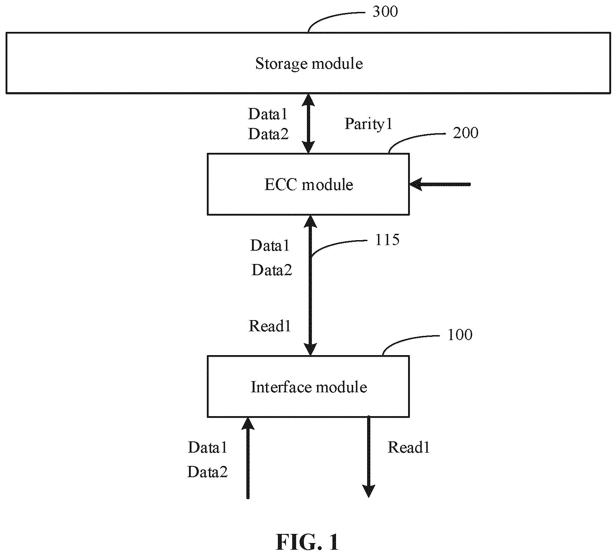

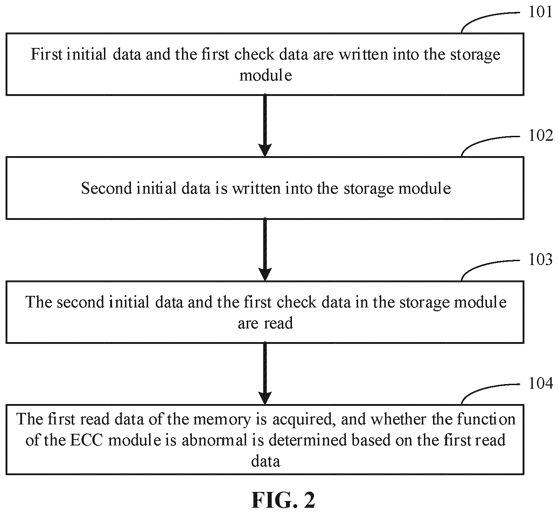

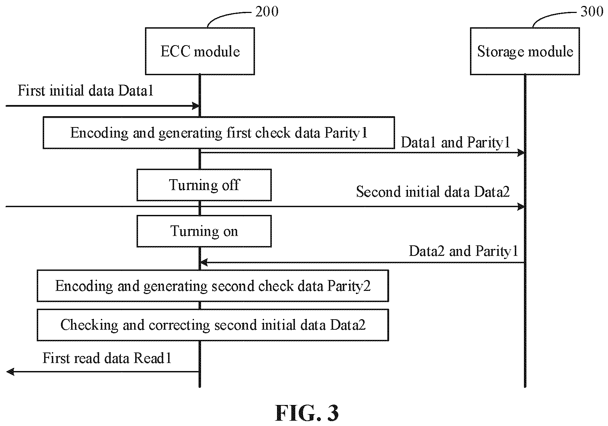

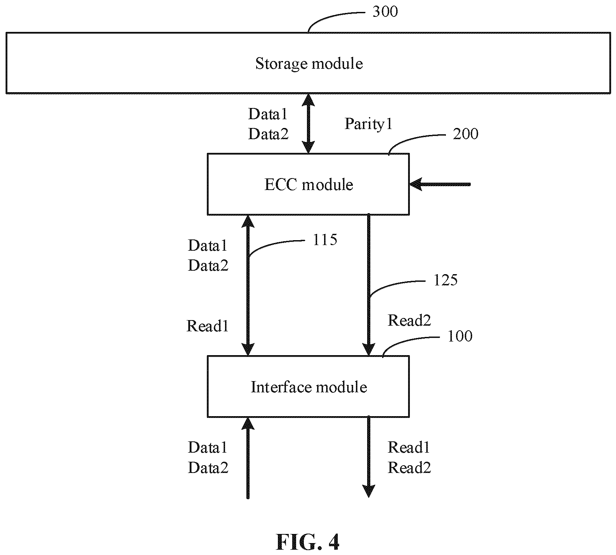

FIG. 1 is a schematic structural diagram of a memory according to the embodiment. FIG. 2 is a schematic flowchart of a test method according to the embodiment. FIG. 3 is a schematic flowchart of specific data of a test method according to the embodiment. FIG. 4 is a schematic structural diagram of another memory according to the embodiment. The test method provided in the embodiment is further described in detail below with reference to the drawings. Details are illustrated as follows.

It is to be noted that, the disclosure is used for the test of ECC, and specifically used to test whether ECC repairs real data according to check data. The real data represents to-be-stored data, and the check data is testing data that is encoded and generated by an ECC module according to the to-be-stored data.

In an example, referring to FIG. 1, the test method is applied to a memory. The memory includes an interface module 100, a storage module 300, and an ECC module 200. The ECC module 200 is configured to perform error check and correction on data stored in the storage module 300. The storage module 300 is configured to store real data and check data. The interface module 100 is configured to acquire the real data to be stored in the storage module 300 and output read data of the memory. Data between the interface module 100 and the ECC module 200 is transmitted by using a first data path 115.

For FIG. 1, the real data includes first initial data Data1. The read data of the memory includes first read data Read1. The check data includes first check data Parity 1.

Referring to FIG. 2, the test method specifically includes operation 101 to operation 104.

At operation 101, the first initial data Data1 and the first check data Parity1 are written into the storage module 300.

Specifically, the first initial data Data1 is written into the storage module 300. The ECC module 200 encodes and generates the first check data Parity 1 corresponding to the first initial data Data1 based on the first initial data Data1, and writes the first check data Parity1 into the storage module 300.

Referring to FIG. 1 and FIG. 3, the interface module 100 acquires the first initial data Data1, and transmits the first initial data Data1 to the ECC module 200. The ECC module 200 compiles and generates the first check data Parity1 according to the first initial data Data1. Then, the ECC module 200 stores the first initial data Data1 and the first check data Parity 1 to the storage module 300.

It is to be noted that, in this embodiment, for example, the first initial data Data1 is a 128-bit binary number, which does not constitute a limitation to this embodiment. In specific application, a data length of the first initial data Data1 may be adjusted according to a data length required to be stored in the memory. Accordingly, the first check data Parity1 that is compiled and generated by the ECC module 200 according to the first initial data Data1 is an 8-bit binary number.

In an example, the first initial data Data1 is stored in a data storage area of the storage module 300, and the first check data Parity1 is stored in a check storage area of the storage module 300. Further, the first initial data Data1 stored in the data storage area is in groups of 8 bits, which is stored in 16 groups, so as to guarantee that storage space of each storage unit in the data storage area is same as storage space of a storage unit in the check storage area. It is to be noted that, the real data stored in the data storage area may be divided according to a division manner of the storage space of the storage unit of the memory. This embodiment does not constitute a limitation to data division during data storage.

At operation 102, second initial data Data2 is written into the storage module 300.

Specifically, the second initial data Data2 is written into a same address of the storage module 300. The second initial data Data2 stored in the storage module 300 covers the first initial data Data1. There is a data difference between the first initial data Data1 and the second initial data.

Referring to FIG. 1 and FIG. 3, before the second initial data Data2 is written into the storage module 300, the ECC module 200 is turned off. The interface module 100 writes the second initial data Data2 into the storage module 300. After the second initial data Data2 is written into the storage module 300, the ECC module 200 is turned on.

Since the memory stores data in the form of electrical level storage, and the data stored with an electrical level may cause the written data to be different from the read data due to the change of the electrical level, ECC is required to perform error check and correction on the written data and the read data. In this embodiment, by controlling the turning on and turning off of the ECC module 200, the ECC module 200 is prevented from transmitting the check data compiled and generated according to the second initial module Data2 to the storage module 300, so that errors is injected into the real data, so as to simulate that there is an error in the data stored in the storage module 300.

In an example, the turning off the ECC module 200 includes: turning off an encoding function of the ECC module 200. The turning on the ECC module 200 includes: turning on the encoding function of the ECC module 200. That is to say, by turning off the encoding function of the ECC module 200, the ECC module 200 is prevented from encoding and generating the check data according to the second initial data Data2.

In another example, the turning off the ECC module 200 includes: turning off a data transmission channel for accessing the check data between the ECC module 200 and the storage module 300. The turning on the ECC module 200 includes: turning on the data transmission channel for accessing the check data between the ECC module 200 and the storage module 300. That is to say, the first check data Parity1 in the storage module 300 is guaranteed to be not covered by turning off the data transmission channel for accessing the check data between the ECC module 200 and the storage module 300. Although the ECC module 200 encodes and generates the check data according to the second initial data Data2, but the check data cannot be stored in the storage module 300.

For a common ECC function of the memory, if only one bit of the real data of the memory changes in the storage module 300, the real data may be repaired according to the check data. If the changed bits of the real data is greater than 1 bit, the ECC module 200 cannot repair initial data. Therefore, in this embodiment, there is only one bit of data difference between the first initial data Data1 and the second initial data Data2, so as to guarantee that the second initial data Data2 after error injection may be repaired by the ECC module.

At operation 103, the second initial data Data2 and the first check data Parity1 in the storage module 300 are read.

Specifically, the second initial data Data2 and the first check data Parity1 in the storage module 300 are read. The ECC module 200 encodes and generates second check data Parity2 corresponding to the second initial data Data2 based on the second initial data Data2, and checks and corrects the second initial data Data2 based on the first check data Parity 1 and the second check data Parity2.

Referring to FIG. 1 and FIG. 3, the storage module 300 reads the second initial data Data2 and the first check data Parity 1 to the ECC module 200. The ECC module 200 encodes and generates the second check data Parity2 corresponding to the second initial data Data2 based on the second initial data Data2. The ECC module 200 checks and corrects the second initial data Data2 according to the first check data Parity1 and the second check data Parity2.

At operation 104, the first read data Read1 of the memory is acquired, and whether the function of the ECC module is abnormal is determined based on the first read data Read 1.

Specifically, the first read data Read1 of the memory is read, and whether the function of the ECC module 200 is abnormal is determined based on the first read data Read1. The first read data Read1 is the second initial data Data2 that is checked and corrected by the ECC module 200.

In an example, if the read first read data Read1 is the same as the to-be-written first initial data Data1, it indicates that the initial data after error injection is successfully repaired by the ECC module 200, and the function of the ECC module 200 is normal. If the read first read data Read1 is different from the to-be-written first initial data Data1, it indicates that the initial data after error injection is not repaired by the ECC module 200, and the function of the ECC module 200 is abnormal.

In addition, referring to FIG. 4, in an example, during reading the first read data Read1 of the memory, the test method further includes that: second read data Read2 of the memory is read. The second read data Read2 is the second check data Parity2 that is encoded and generated by the ECC module 200 based on the second initial data Data2.

In an example, the second read data Read2 is outputted by using a mask pad of the memory.

A mask operation may be involved during normal data reading and writing of the memory, and the mask operation of the memory is based on whether a control end sends a mask and whether related mask functions are turned on. The mask operation is not used during testing the ECC of the memory. That is to say, when testing the ECC, the mask pad of the memory is equivalent to not working. Therefore, by outputting the second read data Read2 with the mask pad, a new pad is not required to be added to the memory, so that an external structure of the memory is not changed.

In an example, the first data path 115 is used for the interface module 100 to transmit the real data to the ECC module 200. A second data path 125 is used for the ECC module 200 to transmit the check data to the interface module 100. By means of classification transmission of the data, the accuracy of data transmission is guaranteed.

For the memory in a normal operation state, the ECC function of the memory does not output the check data after check and repair. In some embodiments, the second data path 125 is turned on based on an external control signal, which further guarantees that the memory outputs the second read data Read2 only when the ECC function is tested.

When there is only one bit of data difference between the first initial data Data1 and the second initial data Data2, there is only one bit of data difference between the first check data Parity 1 and the second check data Parity2.

The determining whether the function of the ECC module 200 is abnormal based on the second read data Read2 includes that: the first check data Parity1 corresponding to the first initial data Data1 is acquired based on an encoding manner of the ECC module 200; the check data corresponding to the first read data Read1 is acquired based on the encoding manner of the ECC module; determining that the function of the ECC module 200 is normal in case that the check data is the same as the first check data Parity 1 and there is one bit of data difference between the check data and the second read data Read2; and determining that the function of the ECC module 200 is abnormal in case that the check data is different from the first check data Parity1 or a data difference between the check data and the second read data Read2 is not one bit. That is to say, the ECC function of the memory may also be tested by means of the read second read data Read2.

In addition, in actual application, the accuracy of a test result may be further guaranteed through double assurance by combining with a manner of testing the real data and the check data.

Since the memory stores data in the form of electrical level storage, and the data stored with an electrical level may cause the written data to be different from the read data due to the change of the electrical level, ECC is required to perform error check and correction on the written data and the read data. In this embodiment, the first initial data and the first check data are stored in the storage module, and then the second initial data is stored in the storage module, that is, error injection is performed on the initial data. Then, whether the ECC function of the memory is normal is determined by means of the first read data read by the memory. That is to say, after the memory is put into use, the check of the ECC function may still be performed in a simple manner, a test environment is real, and the acquired testing data is more reliable.

The above operations are divided only for clear description. During implementation, the operations may be merged into one operation or split some operations into a plurality of operations. Insignificant modifications added into the process or insignificant designs introduced, and core designs without changing the process all fall within the scope of protection of this patent.

Another embodiment of the disclosure provides a test system. The test system is applied to the above test method, and includes: a first data providing module, a second data providing module, a control module and a data analysis module. The first data providing module is configured to provide first initial data to a memory; the second data providing module is configured to provide second initial data to the memory, where there is a data difference between the first initial data and the second initial data; the control module is configured to control the turning on or turning off of an ECC module of the memory according to a control signal; and the data analysis module is configured to acquire first read data outputted by the memory, and determine whether a function of the ECC module is abnormal based on the first read data, where the first read data is the checked and corrected second initial data that is outputted by the memory.

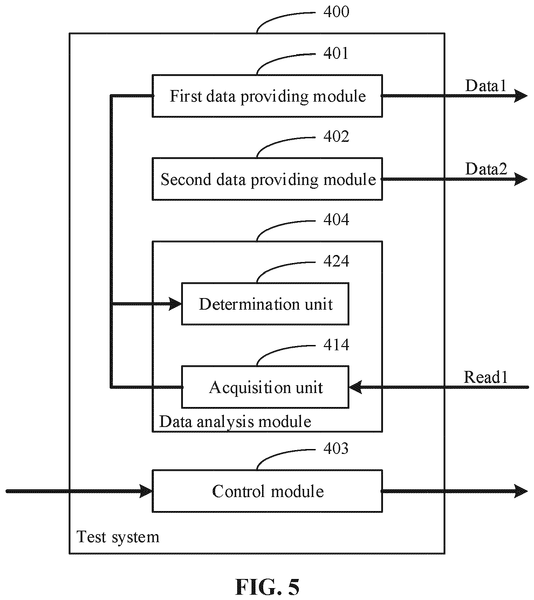

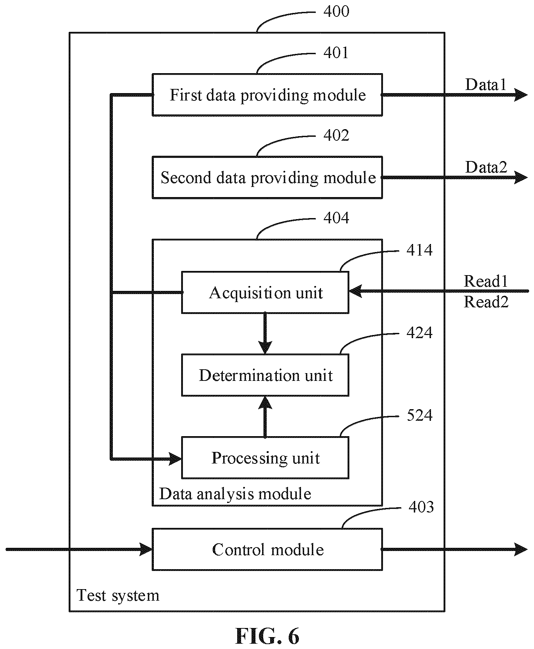

FIG. 5 is a schematic structural diagram of a test system according to the embodiment. FIG. 6 is a schematic structural diagram of another test system according to the embodiment. The test system provided in the embodiment is further described in detail below with reference to the drawings. Details are illustrated as follows.

Referring to FIG. 5, the test system 400 is configured to test an ECC module of a memory, and includes a first data providing module 401, a second data providing module 402, a control module 403, and a data analysis module 404.

The first data providing module 401 is configured to provide first initial data Data1 to the memory.

It is to be noted that, in this embodiment, for example, the first initial data Data1 is a 128-bit binary number, which does not constitute a limitation to this embodiment. In specific application, a data length of the first initial data Data1 may be adjusted according to a data length required to be stored in the memory. Accordingly, the first check data Parity1 that is compiled and generated by the ECC module of the memory according to the first initial data Data1 is an 8-bit binary number.

The second data providing module 402 is configured to provide second initial data Data2 to the memory, and there is a data difference between the first initial data Data1 and the second initial data Data2.

Since the memory stores data in the form of electrical level storage, and the data stored with an electrical level may cause the written data to be different from the read data due to the change of the electrical level, ECC is required to perform error check and correction on the written data and the read data. In this embodiment, by controlling the turning on and turning off of the ECC module, the ECC module is prevented from transmitting the check data compiled and generated according to the second initial module Data2 to the storage module, so that errors is injected into the real data, so as to simulate that there is an error in the data stored in the storage module.

For a common ECC function of the memory, if only one bit of the real data of the memory changes in the storage module, the real data may be repaired according to the check data. If the changed bits of the real data is greater than 1 bit, the ECC module cannot repair initial data. Therefore, in this embodiment, there is only one bit of data difference between the first initial data Data1 and the second initial data Data2, so as to guarantee that the second initial data Data2 after error injection may be repaired by the ECC module.

The control module 403 is configured to control the turning on or turning off of the ECC module of the memory according to a control signal.

In an example, the turning off the ECC module includes: turning off an encoding function of the ECC module. The turning on the ECC module includes: turning on the encoding function of the ECC module. That is to say, by turning off the encoding function of the ECC module, the ECC module is prevented from encoding and generating the check data according to the second initial data Data2.

In another example, the turning off the ECC module includes: turning off a data transmission channel for accessing the check data between the ECC module and the storage module. The turning on the ECC module includes: turning on the data transmission channel for accessing the check data between the ECC module and the storage module. That is to say, the first check data Parity1 in the storage module is guaranteed to be not covered by turning off the data transmission channel for accessing the check data between the ECC module and the storage module. Although the ECC module encodes and generates the check data according to the second initial data Data2, but the check data cannot be stored in the storage module.

The data analysis module 404 is configured to acquire first read data Read1 outputted by the memory, and determine whether a function of the ECC module of the memory is abnormal based on the first read data Read1, and the first read data Read1 is the checked and corrected second initial data Data2 that is outputted by the memory.

Specifically, the data analysis module 404 includes: an acquisition unit 414, configured to acquire the first read data Read1 of memory data; and a determination unit 424, connecting the first data providing module 401 and the acquisition unit 414, and configured to determine whether the function of the ECC module is abnormal based on the first read data Read1 and the first initial data Data1.

For the determination unit 424, if the read first read data Read1 is the same as the to-be-written first initial data Data1, it indicates that the initial data after error injection is successfully repaired by the ECC module, and the function of the ECC module is normal. If the read first read data Read1 is different from the to-be-written first initial data Data1, it indicates that the initial data after error injection is not repaired by the ECC module, and the function of the ECC module is abnormal.

In an example, during reading the first read data Read1 of the memory, it further includes: reading second read data Read2 of the memory. The second read data Read2 is the second check data Parity2 that is encoded and generated by the ECC module based on the second initial data Data2.

Specifically, referring to FIG. 6, the data analysis module 404 is further configured to acquire second read data Read2 outputted by the memory, and the second read data Read2 is the second check data Parity2 that is encoded and generated by the ECC module based on the second initial data Data2.

The determining whether a function of the ECC module is abnormal based on the first read data Read1 includes: determining whether the function of the ECC module is abnormal based on the first read data Read1 and the second read data Read2.

In this example, the data analysis module 404 includes: the acquisition unit 414, a processing unit 524, and the determination unit 424. the acquisition unit 414 is configured to acquire the first read data Read1 and the second read data Read2 that are outputted by the memory; a processing unit 524 connects the first data providing module 401 and the acquisition unit 414, and is configured to acquire first check data Parity1 corresponding to the first initial data Data1 and third check data Parity3 corresponding to the first read data Read1 based on an encoding manner of the ECC module; and the determination unit 424 connects the acquisition unit 414 and the processing unit 524, and is configured to determine whether the function of the ECC module is abnormal based on the first check data Parity 1, the second read data Read2, and the third check data Parity3.

For the determination unit 424, if the third check data Parity3 is the same as the first check data Parity1 and there is one bit of data difference between the third check data Parity3 and the second read data Read2, the determination unit 424 outputs prompt information representing that the function of the ECC module is normal. If the third check data Parity3 is different from the first check data Parity1 or a data difference between the third check data Parity3 and the second read data Read2 is not one bit, the determination unit 424 outputs prompt information representing that the function of the ECC module is abnormal.

In addition, in actual application, the accuracy of a test result may be further guaranteed through double assurance by combining with a manner of testing the real data and the check data.

Since the memory stores data in the form of electrical level storage, and the data stored with an electrical level may cause the written data to be different from the read data due to the change of the electrical level, ECC is required to perform error check and correction on the written data and the read data. In this embodiment, the first initial data and the first check data are stored in the storage module, and then the second initial data is stored in the storage module, that is, error injection is performed on the initial data. Then, whether the ECC function of the memory is normal is determined by means of the first read data read by the memory. That is to say, after the memory is put into use, the check of the ECC function may still be performed in a simple manner, a test environment is real, and the acquired testing data is more reliable.

It is worth mentioning that, all units involved in this embodiment are logical units. In actual application, a logical unit may be a physical unit, a part of the physical unit, or a combination of a plurality of physical units. In addition, in order to highlight the innovative part of the disclosure, this embodiment does not introduce units that are not closely related to resolving the technical problem proposed by the disclosure, but this does not mean that there are no other units in this embodiment.

Those of ordinary skill in the art may understand that the above embodiments are specific embodiments for realizing the disclosure, and in practical application, various changes may be made in form and details without departing from the spirit and the scope of the disclosure.

It is to be noted that, the technical features in the technical solutions described in the embodiments may be arbitrarily combined without conflict. Those skilled in the art can change the sequence of the steps of the above formation method without departing from the protection scope of the disclosure.

The above are only preferred embodiments of the disclosure, and are not used to limit the scope of protection of the disclosure. Any modifications, equivalent replacements and improvements and the like made within the spirit and principle of the disclosure shall be included within the scope of protection of the disclosure.

## Claims

1. A test method, applied to a memory comprising a storage module and an Error Correction Code (ECC) module, the method comprising:
writing first initial data into the storage module, encoding and generating, by the ECC module, first check data corresponding to the first initial data based on the first initial data, and writing the first check data into the storage module;
writing second initial data into a same address of the storage module, wherein the second initial data stored in the storage module covers the first initial data, and there is a data difference between the first initial data and the second initial data;
reading the second initial data and the first check data in the storage module, encoding and generating, by the ECC module, second check data corresponding to the second initial data based on the second initial data, and checking and correcting, by the ECC module, the second initial data based on the first check data and the second check data; and
reading first read data of the memory, and determining whether a function of the ECC module is abnormal based on the first read data, wherein the first read data is the second initial data checked and corrected by the ECC module.

2. The test method of claim 1, wherein the writing the second initial data into the storage module comprises: turning off the ECC module; writing the second initial data into the storage module; and turning on the ECC module after the second initial data is written into the storage module.

3. The test method of claim 2, wherein
the turning off the ECC module comprises: turning off an encoding function of the ECC module; and
the turning on the ECC module comprises: turning on the encoding function of the ECC module.

4. The test method of claim 2, wherein
the turning off the ECC module comprises: turning off a data channel for accessing check data between the ECC module and the storage module; and
the turning on the ECC module comprises: turning on the data channel for accessing check data between the ECC module and the storage module.

5. The test method of claim 1, wherein the determining whether the function of the ECC module is abnormal comprises: determining that the function of the ECC module is normal in case that the read first read data is same as the written first initial data; and determining that the function of the ECC module is abnormal in case that the read first read data is different from the written first initial data.

6. The test method of claim 1, wherein during reading the first read data of the memory, the test method further comprises: reading second read data of the memory, wherein the second read data is the second check data that is encoded and generated by the ECC module based on the second initial data.

7. The test method of claim 6, wherein there is only one bit of data difference between the first initial data and the second initial data, and there is only one bit of data difference between the first check data and the second check data.

8. The test method of claim 7, wherein the determining whether the function of the ECC module is abnormal based on the first read data comprises:
acquiring the first check data corresponding to the first initial data based on an encoding manner of the ECC module;
acquiring check data corresponding to the first read data based on the encoding manner of the ECC module;
determining that the function of the ECC module is normal in case that the check data is same as the first check data and there is one bit of data difference between the check data and the second read data; and
determining that the function of the ECC module is abnormal in case that the check data is different from the first check data or a data difference between the check data and the second read data is not one bit.

9. A test system, applied to the test method of any one of claims 1 to 8, and comprising:
a first data providing module, configured to provide first initial data to a memory;
a second data providing module, configured to provide second initial data to the memory, wherein there is a data difference between the first initial data and the second initial data;
a control module, configured to control turning on or turning off of an Error Correction Code (ECC) module of the memory according to a control signal; and
a data analysis module, configured to acquire first read data outputted by the memory, and determine whether a function of the ECC module is abnormal based on the first read data, wherein the first read data is checked and corrected second initial data that is outputted by the memory.

10. The test system of claim 9, wherein there is only one bit of data difference between the first initial data and the second initial data.

11. The test system of claim 9, wherein the data analysis module comprises:
an acquisition unit, configured to acquire the first read data outputted by the memory; and
a determination unit, connecting the first data providing module and the acquisition unit, and configured to determine whether the function of the ECC module is abnormal based on the first read data and the first initial data.

12. The test system of claim 11, wherein the determining whether the function of the ECC module is abnormal based on the first read data and the first initial data comprises that:
the determination unit is further configured to output prompt information representing that the function of the ECC module is normal in case that the read first read data is same as the first initial data; and
the determination unit is further configured to output prompt information representing that the function of the ECC module is abnormal in case that the read first read data is different from the first initial data.

13. The test system of claim 9, wherein
the data analysis module is further configured to acquire second read data outputted by the memory, wherein the second read data is second check data that is encoded and generated by the ECC module based on the second initial data; and
the determining whether the function of the ECC module of the memory is abnormal based on the first read data comprises: determining whether the function of the ECC module is abnormal based on the first read data and the second read data.

14. The test system of claim 13, wherein the data analysis module comprises:
an acquisition unit, configured to acquire the first read data and the second read data outputted by the memory;
a processing unit, connecting the first data providing module and the acquisition unit, and configured to acquire first check data corresponding to the first initial data and third check data corresponding to the first read data based on an encoding manner of the ECC module; and
a determination unit, connecting the acquisition unit and the processing unit, and configured to determine whether the function of the ECC module is abnormal based on the first check data, the second read data, and the third check data.

15. The test system of claim 14, wherein the determining whether the function of the ECC module is abnormal based on the first check data, the second read data, and the third check data comprises that: the determination unit is further configured to output prompt information representing that the function of the ECC module is normal in case that the third check data is same as the first check data and there is one bit of data difference between the third check data and the second read data; and the determination unit is further configured to output prompt information representing that the function of the ECC module is abnormal in case that the third check data is different from the first check data or a data difference between the third check data and the second read data is not one bit.
